# EUROPEAN PATENT APPLICATION

(11) **EP 4 697 096 A1**
(43) Date of publication of application: **18.02.2026**
(21) Application number: 24194962.7
(22) Date of filing: 16.08.2024
(51) Int. Cl.: G03F 7/00, B23K 26/70

(54) **LASER SYSTEM AND LASER GENERATION METHOD**

(71) Applicant: ASML Netherlands B.V., 5500 AH Veldhoven (NL); TRUMPF Lasersystems for Semiconductor Manufacturing SE, 71254 Ditzingen (DE)
(72) Inventor: YUAN, Jiayue, 5500AH Veldhoven (NL); MARTINS, Daniel, 5500AH Veldhoven (NL); VAN DEN DUNGEN, Clemens, Johannes, Gerardus, 5500AH Veldhoven (NL); LANGE, Marc, Christian, 5500AH Veldhoven (NL); REGAARD, Boris, 71254 Ditzingen (DE); SCHLOSSER, Oliver, 71254 Ditzingen (DE); HOPF, Andreas, Kristian, 71254 Ditzingen (DE)
(74) Representative: ASML Netherlands B.V.

(57) **Abstract**

A laser system comprising reflective optical elements to reflect a laser beam, the reflective optical elements arranged to form a beam path for the laser beam. The laser system comprises a vacuum environment. At least one of the reflective optical elements is particularly arranged in the vacuum environment and mounted on a substrate of the laser system, The laser system comprises a first volume which is maintained under a pressure different from a surrounding atmospheric pressure and, in particular, is purged with a gas. The laser system further comprises pressure detection means arranged to detect a decrease and/or an increase in pressure in the first volume comprised in the substrate.

## Description

### FIELD

The present invention relates to a laser system, a laser powered plasma based EUV generation system comprising such a laser system, an exposure apparatus comprising such laser produced plasma based EUV generation system and a laser generation method

### BACKGROUND

Light generated by means of a radiation source can be used by exposure apparatuses for semiconductor manufacturing processes. Examples of such exposure apparatuses are a lithographic apparatus, a metrology, or an inspection apparatus, more specifically a mask inspection apparatus and even more specifically an actinic mask inspection apparatus.

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (e.g., a photoresist or resist) provided on a substrate. To project a pattern on a substrate a lithographic apparatus may use electromagnetic radiation. The wavelength of this radiation determines the minimum size of features which can be formed on the substrate. A lithographic apparatus, which uses EUV radiation, having a wavelength within the range 4-20 nm, for example 6.7 nm or 13.5 nm, may be used to form smaller features on a substrate than a lithographic apparatus which uses, for example, radiation with a wavelength of 193 nm.

An (actinic) mask inspection apparatus is an apparatus that is configured for measuring dimensions or detecting defects in masks or mask blanks. EUV lithography uses reflective surfaces instead of lenses as optics. Mask blanks used in EUV lithography generally have a multilayer structure which functions as a Bragg reflector, the multilayers may be alternatingly Molybdenum and Silicon. If a defect exists in this structure, the projected pattern will be deformed in the lithographic process. Therefore, mask inspection to check whether a defect is present is considered a requirement for a mass-production process. EUV mask inspection may be used for several purposes and in several different stages. Firstly, it can be used for the detection of phase defects that may occur in mask blanks. Such phase defects may occur during the manufacturing of the multilayer stack of the mask blank. If undetected, these phase defects are printed on all chips printed with the part of a mask containing the phase defects. Such phase defects may be correctly detected by using the same or similar (13.5nm) actinic EUV wavelength as the lithography tool. Secondly, mask inspection can be used for patterned mask inspection and can be carried out for the quality control of EUV patterned masks. For example, the mask inspection can be used to measure critical dimensions on the mask blank. In addition to phase defects, absorber pattern defects on the surface can be detected. Thirdly, mask inspection can be used for simulating exposure and determining the deterioration of optical contrast of a defect detected in the actinic inspection. Forth, the mask inspection can be used for optical proximity correction (OPC) evaluation or during mask repair process so as to improve pattern transfer fidelity. Further, it can be used for inspecting optical contrast after fixing the defect. In addition to the above, mask inspection can also be used to measure small particle/amplitude effects.

For laser powered plasma based Extreme Ultra Violet, EUV, light generation, use may be made of a two pulse setup. First, a pre-pulse is transmitted to a droplet of metal or alloy. The pre-pulse may also be identified as a conditioning pulse. The pre-pulse may provide for a conditioning of the droplet of metal or alloy, such as to form a plasma or to shape the droplet. Second, a main pulse is transmitted to the conditioned droplet, so as to initiate the generation of EUV light. Optionally, multiple pre-pulses may be transmitted to the metal or alloy, for example a conditioning pre-pulse to shape the droplet of metal or alloy and a plasma generation pre-pulse to generate a plasma from the shaped droplet of metal or alloy. The main pulse may also be identified as an excitation pulse.

Use may be made of optical elements such as mirrors to project the laser pre-pulse and/or the main pulse onto the metal or alloy. The optical elements, such as the mirrors may be arranged on respective substrates. A peak power of the one or more pre-pulses and/or a peak power of the main pulse may be high. Further a repetition frequency of the pulses may be high. As a result, a puncture or destruction of the optical element may result in a damage to the substrate on which the optical element is arranged, which may result in a burn through of the substrate. But it is not only the optical element that may burn through; in the event of a misalignment of one or more of the laser beams, surrounding housing parts of the laser system may also be burnt through, which can lead to dangerous situations. In other words, due to the burn through, high power laser pulses, such as the pre-pulse or the main pulse, may deviate from an intended pulse propagation path, which may result in danger, e.g. to a human operator which may be subject to the pre-pulses or main pulses deviating from the intended pulse propagation path.

The optical elements may be particularly but not necessarily arranged in a vacuum environment or in an environment purged with a gas.

In principle, the problem is to prevent damage to operating personnel in the event of the substrate or surrounding housing parts burning through.

### SUMMARY

The present invention aims to enhance laser safety.

According to an aspect of the invention, there is provided a laser system comprising reflective optical elements configured to reflect a laser beam, the reflective optical elements being arranged to form a beam path for propagation of the laser beam, wherein the laser system further comprises a vacuum environment, wherein at least one of the reflective optical elements is particularly arranged in the vacuum environment, the at least one of the reflective optical elements is mounted on a substrate of the laser system, wherein the laser system comprises a first volume which is maintained under a pressure different from a surrounding atmospheric pressure and, in particular, is purged with a gas, the laser system further comprising pressure detection means arranged to detect a decrease and/or an increase in pressure in the first volume comprised in the substrate.

In an embodiment, the first volume is formed within the substrate or adjacent to at least one wall of a housing substantially enclosing the vacuum environment in an intermediate chamber bordered by the wall.

In an embodiment, the laser system further comprises a switching means connected to the pressure detection means, wherein the switching means is arranged to switch-off the laser system upon detection of a decrease in pressure by the pressure detection means.

In an embodiment, the laser system further comprises a laser source configured to generate the laser beam and a housing that substantially encloses the vacuum environment, wherein a laser beam burn through resistance of the housing is dimensioned to provide that a burn through time of the laser beam burning through the wall of the housing exceeds a switch-off time to switch-off the laser system by the switching means.

In an embodiment, the first volume is arranged behind the reflective optical element.

In an embodiment, the laser system further comprises a second volume wherein at least part of the beam path extends in the second volume, wherein the second volume is purged with and maintained under pressure of the gas.

In an embodiment, the laser system further comprises a gas supply duct between the first volume and the second volume configured to supply the gas from one of the first volume and the second volume to the other one of the first volume and the second volume.

In an embodiment, the laser system further comprises a gas inlet duct and/or a gas outlet duct, wherein the pressure detection means are arranged at the gas inlet duct and/or the gas outlet duct.

In an embodiment, the substrate comprises a fused silica, a silicon carbide, diamond or ZnSe.

According to an aspect of the invention, there is provided a laser powered plasma based EUV generation system comprising the laser system according to the invention.

In an embodiment, the laser produced plasma based EUV generation system comprises at least one of a conditioning laser source configured to generate a conditioning laser beam and an excitation laser source configured to generate an excitation laser beam wherein the laser powered plasma based EUV generation system is configured in that the at least one of the conditioning laser beam and the excitation laser beam propagates along the beam path.

In an embodiment, the switching means are configured to switch-off the at least one of the conditioning laser source and the excitation laser source.

According to an aspect of the invention, there is provided an exposure apparatus comprising the laser produced plasma based EUV generation system according to the invention.

According to an aspect of the invention, there is provided a laser generation method comprising reflecting a laser beam along a beam path by reflective optical elements, wherein at least one of the reflective optical elements is particularly arranged in a vacuum environment, wherein the at least one of the reflective optical elements is mounted on a substrate, wherein the laser system comprises a first volume, the method comprising maintaining the first volume under a pressure different from a surrounding atmospheric pressure and, in particular, purging the volume with a gas, and detecting by pressure detection means a decrease and/or an increase in pressure in the first volume comprised in the substrate.

In an embodiment, the laser generation method further comprises forming the first volume within the substrate or adjacent to at least one wall of a housing substantially enclosing the vacuum environment in an intermediate chamber bordered by the wall.

In an embodiment, the laser generation method further comprises switching-off by a switching means connected to the pressure detection means, the laser system upon detection of a decrease in pressure by the pressure detection means.

In an embodiment, upon detection of a decrease in pressure by the pressure detection means, the laser system is switched off prior to exceeding a burn through time of the laser beam burning through a wall of a housing that substantially encloses the vacuum environment.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts an alternative radiation source; and
- Figure 3 depicts a highly schematic view of a laser system according to an embodiment of the invention.

### DETAILED DESCRIPTION

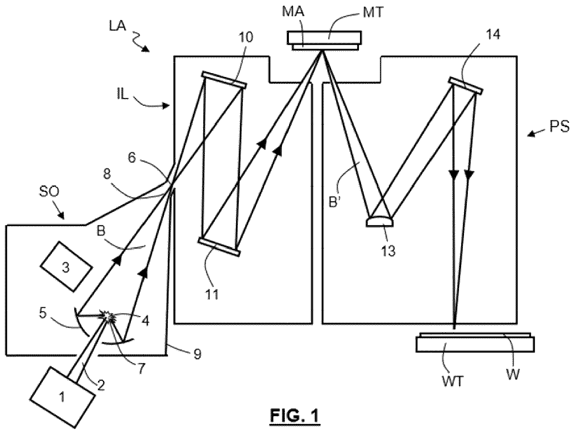

Figure 1 shows a lithographic system comprising a radiation source SO and a lithographic apparatus LA. The radiation source SO is configured to generate EUV radiation B and to supply the EUV radiation B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation B before the EUV radiation B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation B interacts with the patterning device MA. As a result of this interaction, a patterned EUV radiation B' is generated. The projection system PS is configured to project the patterned EUV radiation B' onto the substrate W. For that purpose, the projection system PS may comprise a plurality of mirrors 13,14 which are configured to project the patterned EUV radiation B' onto the substrate W held by the substrate table WT. The projection system PS may apply a reduction factor to the patterned EUV radiation B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The lithographic apparatus LA and radiation source SO described herein can be used in method for performing a circuit layout patterning process. A circuit layout patterning method comprises receiving a substrate with a photoresist layer. The method further comprises directing EUV radiation from radiation source to the photoresist layer to form a patterned photoresist layer. The method further comprises developing and etching the patterned photoresist layer to form a circuit layout.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel (i.e., a target material), such as tin (Sn) which is provided from, e.g., a fuel generator 3. Although tin is referred to in the following description, any suitable fuel may be used. The fuel may, for example, be in liquid form, and may, for example, be a metal or alloy. The fuel generator 3 may comprise a nozzle configured to direct the fuel, e.g. in the form of droplets, along a trajectory towards a plasma formation region 4. The laser beam 2 is incident upon the fuel at the plasma formation region 4. The deposition of laser energy into the tin creates a plasma 7 at the plasma formation region 4. Radiation, including EUV radiation, is emitted from the plasma 7 during de-excitation and recombination of electrons with ions of the plasma 7.

The EUV radiation from the plasma 7 is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation B. The EUV radiation B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a free electron laser (FEL) or a discharge produced plasma (DPP) source may be used to generate EUV radiation.

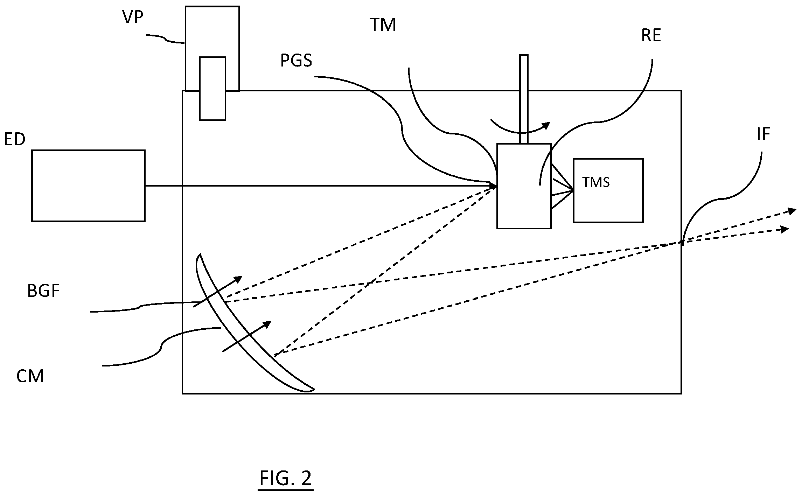

Figure 2 depicts an alternative radiation source. For generating plasma target material TM, like tin or xenon may be provided to a rotating element (RE), like for example rotating wheels, cylinder, or a drum or variations thereof. Target material may be provided by a target material source TMS in liquified form to the one or more rotating elements, e.g. by means of a target material bath. Alternatively, target material may also be provided in solid or frozen form (e.g. Xenon). Gaseous target material may be sprayed onto the rotating element to replace target material transformed to plasma at plasma generation site PGS. According to embodiments the rotating element would be cold enough to solidify the target material. An excitation device ED may be used to assist in plasma formation. According to embodiments this excitation device is a laser like a solid-state or gas laser. Reflective optics, like one or more mirrors can be used to reflect the EUV light generated to the intermediate focus IF. According to embodiments, the reflective optics are a collector mirror CM. Buffer gas flow BGF may be provided to mitigate debris present in the radiation source. Also a vacuum pump VP may be provided.

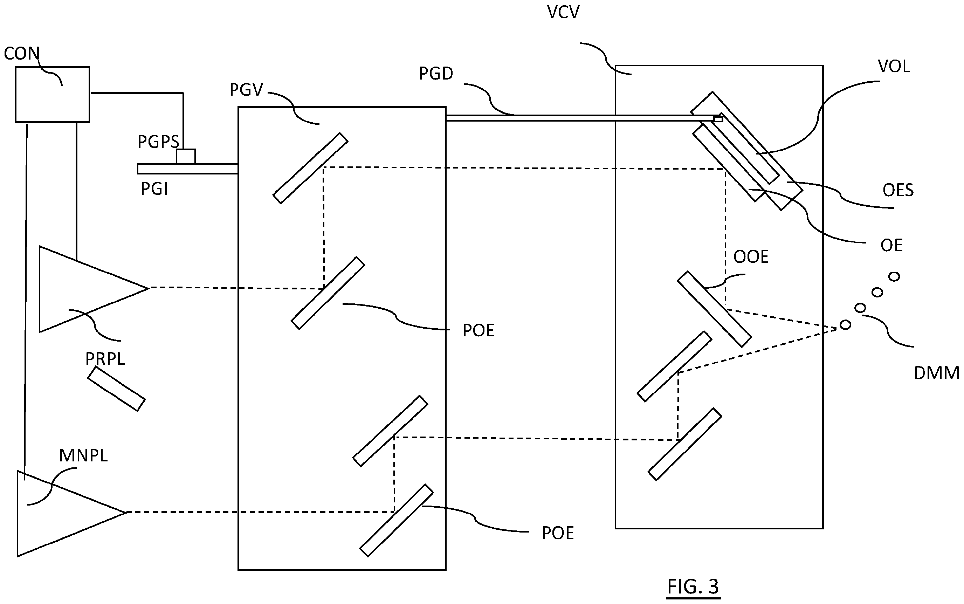

Figure 3 depicts a highly schematic view of a laser system according to an embodiment of the invention. The laser system comprises a pre-pulse laser source PRPL which is configured to generate a pre-pulse and a main pulse laser source MNPL which is configured to generate a main pulse. The pre-pulse may condition a quantity of metal or alloy, such as a droplet thereof. The main pulse may provide for an excitation of the conditioned metal or alloy to emit a light, such as an Extreme Ultra Violet, EUV, light. The pre-pulse may also be identified as a conditioning pulse. The main pulse may be identified as an excitation pulse. As described above, dual pre-pulses may be generated, e.g. a first conditioning pulse to shape the droplet of molten metal or alloy and a second conditioning pulse to generate a plasma from the shaped droplet. The main pulse may then energize the plasma to generate the Extreme Ultra Violet, EUV, light. In order for the pre-pulse to be directed to the droplet of molten metal or droplet of molten alloy DMM, projection elements are comprised in the laser system, such as in the present example reflective mirrors. In the present embodiment, a subset of the optical elements are in the present embodiment arranged in a vacuum environment, but this has not necessarily to be the case, as the subset of the optical elements may also be arranged in an ambient environment. In an embodiment, another subset of the reflective optical elements is arranged in a second volume PGV purged with a gas, such as Argon gas. The output of the pre-pulse laser source is reflected by reflective optical elements POE in the volume purged with the gas PGV, and directed to the vacuum environment, where it is projected by reflective optical element OOE, in the present example a reflective mirror. It is to be understood that in other embodiments, the purged volume could be omitted, e.g. the reflective optical elements being arranged in the vacuum environment. The reflective optical element is arranged on, e.g. supported by, a substrate OES. For example, the reflective optical element is mounted on the substrate or the reflective optical element is formed by a coating such as a reflective coating, arranged on the substrate. The pre-pulse is reflected towards a droplet of the metal or alloy by an output reflective optical element OOE.

The main pulse emitted by the man pulse laser source MNPL is reflected by reflective optical elements ROE in the volume purged with the gas PGV, and directed to the vacuum environment, where it is projected by main pulse reflective optical elements MPOE, in the present example reflective mirrors. It is to be understood that in other embodiments, the purged volume could be omitted. The main pulse is reflected towards the metal or alloy that has been subjected to the pre-pulse in order to energize the metal or alloy (e.g. conditioned by the pre-pulse to form a plasma) to generate the Extreme Ultra Violet, EUV, light.

As described above, a peak power of the one or more pre-pulses and/or a peak power of the main pulse may be high. Also a repetition frequency of the pulses may be high. As a result, a puncture or destruction of the reflective optical element may result in a damage to the substrate on which the reflective optical element is arranged, which may result in a burn through of the substrate. If the one or more pre-pulses and/or the main pulse are misaligned, i.e. run outside a predetermined beam path, not only the reflective optical element but also at least one wall of a housing substantially enclosing the vacuum environment may be damaged and pierced. Due to the burn through, high power laser pulses, such as the pre-pulse or the main pulse, may deviate from an intended pulse propagation path, which may result in danger, e.g. to a human operator which may be subject to the pre-pulses or main pulses deviating from the intended pulse propagation path.

According to an aspect of the invention, a first volume VOL is provided in the substrate, the first volume is arranged behind the reflective optical element. The first volume may form a confined space configured to be purged with a gas, such as a purging gas. The first volume may be understood as a recess or cavity configured to be purged with the gas. The first volume is configured to be maintained under pressure of the gas. The laser system further comprises pressure detection means arranged to detect a decrease in pressure of the gas in the first volume comprised in the substrate. The gas may comprise any gas, such as any suitable purging gas. A pressure of the gas may for example be in any suitable range. Alternatively, the first volume VOL may also be arranged adjacent to a wall of a housing substantially enclosing the vacuum environment, in an intermediate chamber bordered by the wall.

The pressure detection means may for example comprise a gas pressure sensor or a gas pressure activated switch. The gas in the volume may comprise any suitable gas, such as a purging gas. Accordingly, use may be made of a gas that may already be employed in and supplied to the laser system, hence facilitating a gas supply as use may be made of an already present gas supply. The pressure detection means may be arranged at or in the first volume. Alternatively, the pressure detection means may be arranged in a gas supply duct of the laser system, which gas supply duct is configured to supply the gas to the volume. A change of the gas pressure in the first volume would result in a change of the gas pressure in the gas supply duct which may then be detected by the pressure detection means.

In case a damage to the reflective optical element or the wall of the housing would occur, the high power of the laser pulses may lead to burning of a material of the reflective optical element and/or the substrate and/or the wall of the housing, potentially resulting in further damage to the reflective properties of the reflective optical element or resulting in personal injury. A continued exposure of the damaged reflective optical element or the wall of the housing to the laser pulses may result in a progressive burning in of the substrate or the wall of the housing, which may result in a burn through of the substrate or the wall of the housing after some time. With high power laser pulses, a process of burn in and burn through may occur within a relatively short time, e.g. minutes or even faster. According to the present invention, the substrate comprises the first volume filled with the pressurized gas. In case of a burn through of the substrate or the walls of the housing by the high power laser pulses, e.g. in the present example the pre-pulses, the substrate confining the first volume may be damaged due to the burning process, causing the gas to escape from the first volume. The environment of the first volume may for example be a vacuum environment causing the gas to discharge from the volume. As a result, a pressure of the gas in the volume may decrease, which may be detected by the pressure detection means.

The detection of burn through by means of the providing of the first volume in the substrate, the pressuring the first volume by a gas and the detection of a pressure drop signaling a burn through, may provide for a fast and reliable detection of a burn through, thereby reducing a risk of further damage to a human operator as well as to other parts of the laser system The burning in of the substrate may result in a damage to the substrate confining the volume at a relatively early stage of progressive damage, resulting in a pressure drop of the gas in the volume at a relatively early stage.

In an embodiment, the laser system further comprises a switching means connected to the pressure detection means, wherein the switching means is arranged to switch-off the laser system upon detection of a decrease in pressure by the pressure detection means. A decrease in pressure may result from a damage, such as a burn through, of the substrate, causing a leak of the gas as held in the volume. The switching means may be configured to switch off the laser system upon detection of the pressure decrease. The switching means may for example comprise a controller CON, such as a microcontroller or a programmable logic control device, which is connected to the pressure detection means, such as in the present example the pressure sensor PGPS, which sensor and location will be explained in more detail below. The switching means is connected to the pressure detection means to receive a signal from the pressure detection means. Accordingly, in the present example, the controller is connected to the pressure sensor PGPS to receive a signal representative of the pressure (in case the pressure detection means comprise a pressure sensor) or a signal representative of a pressure loss (in case the pressure detection means comprise a pressure switch that is configured to switch upon a decrease in pressure, e.g. below a predetermined pressure threshold).and is configured to, in response to receiving from the pressure detection means a signal that signals a decrease of pressure, control the switching off of the laser system.

The switching means, such as in the present example the controller, may be configured to switch off the laser system in various ways.

For example, the controller may be connected to the pre-pulse laser source and be configured to drive the pre-pulse laser source to switch off in case a decrease of pressure is signaled. In the present example, the reflective optical element that is provided with the first volume in the substrate thereof is exposed by the pre-pulse laser source, accordingly a switch off of the pre-pulse laser source enabling to immediately stop the exposure of the reflective optical element undergoing the burning by the pre-pulse laser pulses. Furthermore, the controller may be connected to the main pulse laser source and be configured to drive the main pulse laser source to switch off in case a decrease of pressure is signaled.

It will be understood that the laser system may be switched off by the controller in any other suitable way. For example, the controller may drive a power switch to switch off power to the laser source so as to stop the laser source from operating.

The laser system may further comprise a housing HS that substantially encloses the vacuum environment. A laser beam burn through resistance of the housing, i.e. a time required for the laser beam to burn through the housing is dimensioned to provide that a burn through time of the laser beam burning through the wall of the housing exceeds a switch-off time to switch-off the laser system by the switching means. Accordingly, the laser system is configured to switch off as a result of the detected pressure drop by the pressure detection means, before a burn through of the housing, i.e. before laser radiation may be leak outside the housing as a result of the burn through.

In an embodiment, the first volume is arranged behind the reflective optical element, i.e. at the side of the reflective optical element facing away from the surface of the reflective surface thereof that reflects the laser pulses. As the volume is arranged behind the reflective optical element, a burn through of the reflective optical element may result in a leakage of the gas from the volume by burn through, even before burn through of a backside of the substrate. Accordingly, a fast response, i.e. a fast switch-off may be provided upon burn through of the reflective optical element, thus to enhance a safety of the laser system.

In an embodiment, as depicted in Figure 3, the laser system further comprises a second volume PGV wherein at least part of the beam path of the laser beam extends in the second volume, wherein the second volume is purged with and maintained under pressure of the gas. Accordingly, the gas in the first volume in the substrate of the reflective optical element or alternatively in or adjacent to a wall of a housing substantially enclosing the vacuum environment (not shown) may be a same gas as the gas in the purging volume of the laser system. Thereby, a supply of the gas may be simplified, as a purging gas already present in the laser system for the purging of a part of the laser system, may be used for the purpose of the present invention. For example, the laser system may further comprise a gas supply duct PGD between the first volume and the second volume configured to supply the gas from one of the first volume and the second volume to the other one of the first volume and the second volume.

In an embodiment, the laser system further comprises a gas inlet duct, such as the purging pas inlet PGI connected to the purging gas volume PGV, wherein the pressure detection means are arranged at the gas inlet duct. In case of a burn through of the reflective optical element OE, the substrate comprising the purging gas filled volume VOL may burn through from the side of the reflective optical element to the volume, resulting in a leakage of the purging gas from the volume into the vacuum environment. Consequently, a purging gas pressure in the volume may drop, resulting, via the purging gas duct PGD, into a pressure drop of the purging gas in the purging gas volume PGV, which may be detected by the pressure detection means at the purging gas inlet thereof. As a result, an added complexity of equipment in the vacuum environment may be very low, as the purging gas duct to the substrate of the reflective optical element and the purging gas filled volume in the substrate of the reflective optical element may be required.

The substrate may for example comprise a fused silica or a silicon carbide.

Although the gas filled first volume within the substrate of the reflective optical element adjacent to the wall of the housing (not shown) has in case of the reflective optical element been described with reference to a single reflective optical element arranged in a beam propagation path of the pre-pulse laser, i.e. the conditioning laser, the laser system according to the invention may comprise plural reflective optical elements each arranged on a respective substrate comprising a respective first volume purged with and maintained under pressure with a gas. The plural reflective optical elements may be associated with the beam propagation path of the pre-pulse laser, the beam propagation path of the main-pulse laser, or both the beam propagation paths of the pre-pulse laser and the main pulse laser. Accordingly, a burn through of the substrate one or more of the respective reflective optical elements may be detected by the pressure detection means. Each first volume may be provided with a respective pressure detection means, for example in case of separate supplies of gas to the respective first volumes. As another example, the first volumes may be connected to a common gas supply, in which case the pressure detection means may be arranged at the common gas supply, such as at a common gas inlet, enabling to detect a decrease in pressure associated with a burn through of any one of the first volumes.

As a further alternative example, not depicted in Figure 3, the volume may be a confined volume that is filled with a gas, e.g. at the manufacturing of the laser system or periodically brought up to pressure upon performing maintenance on the laser system. In such embodiment, the pressure detection means may be arranged in or at the volume.

The laser system as described with reference to Figure 3 may be comprised in a laser powered plasma based EUV generation system, such as the laser powered plasma based UEV generation system described with reference to Figures 1 and 2 above. Alternatively, the described laser system according to the present invention may be comprised in any other laser system. A damage of the reflective optical element, and consequential damage to the substrate carrying the reflective optical element, may be detected by the pressure decrease as described.

The laser produced plasma based EUV generation system may comprise at least one of a conditioning laser source configured to generate a conditioning laser beam and an excitation laser source configured to generate an excitation laser beam wherein the laser powered plasma based EUV generation system is configured in that the at least one of the conditioning laser beam and the excitation laser beam propagates along the beam path. The switching means may be configured to switch-off the at least one of the conditioning laser source and the excitation laser source.

According to a further aspect of the invention, there is provided an exposure apparatus comprising the laser produced plasma based EUV generation system according to the invention.

According to a yet further aspect of the invention, there is provided a laser generation method comprising reflecting a laser beam along a beam path by reflective optical elements, wherein at least one of the reflective optical elements is arranged in a vacuum environment, wherein the at least one of the reflective optical elements is mounted on a substrate, wherein the substrate comprises a first volume, the method comprising purging the first volume with and maintaining the first volume under pressure of a gas, and detecting by pressure detection means a decrease and/or an increase in pressure of the gas in the first volume comprised in the substrate. The laser generation method according to the present invention may provide the same or similar effects and advantages as the laser system according to the present invention. Furthermore, the same or similar embodiments may be provided as described with reference to the laser system according to the invention, the embodiments providing the same or similar effects as described with reference to the laser system according to the invention.

For example, the laser generation method may further comprise switching-off by a switching means connected to the pressure detection means, the laser system upon detection of a decrease and/or an increase in pressure by the pressure detection means. For example, upon detection of a decrease and/or an increase in pressure by the pressure detection means, the laser system is switched off prior to exceeding a burn through time of the laser beam burning through a wall of a housing that substantially encloses the vacuum environment.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrates) or mask (or other patterning devices). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical, and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A laser system comprising reflective optical elements configured to reflect a laser beam, the reflective optical elements being arranged to form a beam path for propagation of the laser beam, wherein the laser system further comprises a vacuum environment, wherein at least one of the reflective optical elements is particularly arranged in the vacuum environment, the at least one of the reflective optical elements is mounted on a substrate of the laser system, wherein the laser system comprises a first volume which is maintained under a pressure different from a surrounding atmospheric pressure and, in particular, is purged with a gas, the laser system further comprising pressure detection means arranged to detect a decrease and/or an increase in pressure in the first volume.

2. The laser system according to claim 1, wherein the first volume is formed within the substrate or adjacent to at least one wall of a housing substantially enclosing the vacuum environment in an intermediate chamber bordered by the wall.

3. The laser system according to claim 1 or 2, further comprising a switching means connected to the pressure detection means, wherein the switching means is arranged to switch-off the laser system upon detection of a decrease and/or an increase in pressure by the pressure detection means.

4. The laser system according to claim 3, further comprising a laser source configured to generate the laser beam and a housing that substantially encloses the vacuum environment, wherein a laser beam burn through resistance of the housing is dimensioned to provide that a burn through time of the laser beam burning through the wall of the housing exceeds a switch-off time to switch-off the laser system by the switching means.

5. The laser system according to any one of the preceding claims, wherein the first volume is arranged behind the reflective optical element.

6. The laser system according to any one of the preceding claims, further comprising a second volume wherein at least part of the beam path extends in the second volume, wherein the second volume is purged with and maintained under pressure of the gas.

7. The laser system according to claim 5, further comprising a gas supply duct between the first volume and the second volume configured to supply the gas from one of the first volume and the second volume to the other one of the first volume and the second volume.

8. The laser system according to any one of the preceding claims, further comprising a gas inlet duct and/or a gas outlet duct, wherein the pressure detection means are arranged at the gas inlet duct and/or the gas outlet duct.

9. The laser system according to any one of the preceding claims, wherein the substrate comprises a fused silica, a silicon carbide, diamond or ZnSe.

10. A laser powered plasma based EUV generation system comprising the laser system according to any one of the preceding claims.

11. The laser produced plasma based EUV generation system according to claim 9 comprising at least one of a conditioning laser source configured to generate a conditioning laser beam and an excitation laser source configured to generate an excitation laser beam wherein the laser powered plasma based EUV generation system is configured in that the at least one of the conditioning laser beam and the excitation laser beam propagates along the beam path.

12. The laser produced plasma based EUV generation system according to claim 10, wherein the switching means are configured to switch-off the at least one of the conditioning laser source and the excitation laser source.

13. An exposure apparatus comprising the laser produced plasma based EUV generation system according to any one of claims 10-12.

14. A laser generation method comprising reflecting a laser beam along a beam path by reflective optical elements, wherein at least one of the reflective optical elements is particularly arranged in a vacuum environment, wherein the at least one of the reflective optical elements is mounted on a substrate, wherein the laser system comprises a first volume, the method comprising maintaining the first volume under a pressure different from a surrounding atmospheric pressure and, in particular, purging the volume with a gas, and detecting by pressure detection means a decrease and/or an increase in pressure in the first volume.

15. The laser generation method according to claim 14, further comprising forming the first volume within the substrate or adjacent to at least one wall of a housing substantially enclosing the vacuum environment in an intermediate chamber bordered by the wall.

16. The laser generation method according to claim 14, further comprising switching-off by a switching means connected to the pressure detection means, the laser system upon detection of a decrease and/or an increase in pressure by the pressure detection means.

17. The laser generation method according to claim 14, wherein, upon detection of a decrease and/or an increase in pressure by the pressure detection means, the laser system is switched off prior to exceeding a burn through time of the laser beam burning through a wall of a housing that substantially encloses the vacuum environment.
